# EUROPEAN PATENT APPLICATION

(11) **EP 4 734 697 A2**
(43) Date of publication of application: **29.04.2026**
(21) Application number: 25204708.9
(22) Date of filing: 25.09.2025
(51) Int. Cl.: H10D 30/01, H10D 30/47, H10D 30/83, H10D 30/87, H10D 62/822, H10D 62/13, H10D 62/17, H10D 62/832

(54) **TRENCH FIELD-EFFECT TRANSISTOR**

(30) Priority: 02.10.2024 US 202463702267 P; 17.07.2025 US 202519272882
(71) Applicant: Semiconductor Components Industries, LLC, Scottsdale, AZ 85250 (US)
(72) Inventor: BHALLA, Anup, 08850 Princeton Junction, NJ (US); FURSIN, Leonid, Princeton Junction, NJ (US)
(74) Representative: Manitz Finsterwald Patent- und Rechtsanwaltspartnerschaft mbB

(57) **Abstract**

A trench field-effect transistor (FET) is disclosed. The trench FET includes a mesa having a source region (220) and a channel region (210) extending vertically under the source region. The trench FET further includes a gate material (216) formed with a different material compared to the mesa and contacting the sides of the channel region. In addition, the trench FET includes a shield region (212) formed under the gate material, and also includes a drain layer (206) located beneath the channel region.

## Description

This application claims the benefit of provisional patent application No. 63/702,267, filed October 2, 2024, which is hereby incorporated by reference herein in its entirety.

### FIELD OF THE DISCLOSURE

The technology of the disclosure relates generally to field-effect transistors (FETs) and, more particularly, to trench FETs with reduced footprint.

### BACKGROUND

Power electronics may be used to control the conversion and distribution of electric power. For example, switching power converters may be used to create a direct current ("DC") voltage from an alternating current ("AC") voltage by switching current through a magnetic element such as an inductor. Conversely, inverters can be used to convert a DC voltage to an AC voltage. In these and other forms of power electronics, power switches may be used to control the conversion and flow of power through the power-conversion system and to the electronic circuitry to be powered by the device. Specifically, power conversion may be performed by switching power converters or invertors that operate by toggling one or more respective switches between an ON-state (also referred to as a closed state or a conductive state) and an OFF-state (also referred to as an open state or a non-conductive state).

Power transistors may be used in power conversion systems and/or solid-state protection applications to drive high currents and to withstand large voltages. When used in such power applications, it may be desirable for one or more power transistors to have a low on-state resistance (RON), thereby limiting unwanted power loss and heat generation. Inventors of embodiments of the present disclosure have recognized that lowering the on-state resistance of a power transistor for a given application typically comes at the expense of larger die size and increased cost. Inventors of embodiments of the present disclosure have also recognized that certain techniques for reducing the on-state resistance of a power transistor may come at the further expense of reducing the breakdown voltage (BV) of the power transistor. Embodiments of the present disclosure may address one or more of these challenges.

### SUMMARY

Aspects disclosed in the detailed description are related to a power switching device, and particularly to a trench FET, with reduced footprint and thus lower on-state resistance (RON) for a given semiconductor die area.

According to one example, a trench field-effect transistor (FET) includes a mesa having a source region and a channel region extending vertically under the source region, a gate material formed with a different material compared to the mesa and contacting the sides of the channel region, a shield region formed under the gate material, and a drain layer located beneath the channel region. In some examples, the trench FET further includes a current spreading layer located between the channel region and the drain layer. In the same or different examples, the channel region comprises a central channel located between vertical channels disposed alongside respective sidewalls of the mesa, and the vertical channels have a higher doping than the central channel. In the same or different examples, the channel region comprises a central channel located between vertical channels disposed alongside respective sidewalls of the mesa, and the vertical channels have a lighter doping than the central channel. In the same or different examples, the source region further includes a first source-region portion and a second source-region portion, wherein the second source-region portion is located above the first source-region portion and includes a higher doping concentration than the first source-region portion. In the same or different examples, the trench FET further includes a metal plug located on the shield region and adjacent to the gate material. In the same or different examples, the metal plug is in direct electrical contact with the shield region and the gate material. In the same or different examples, the trench FET further includes a dielectric material located above the gate material. In the same or different examples, the gate material forms one of a heterojunction or Schottky-type contact to the channel region. In the same or different examples, a super-junction structure located beneath the channel region.

According to another example, a trench FET includes a mesa having a source region and a channel region extending vertically under the source region, a sidewall layer located along sides of the mesa and including a same doping type as the source region and the channel region, a gate material contacting the sidewall layer, the gate material formed with a different material than the mesa and the sidewall layer, a shield region formed under the gate material, and a drain layer located beneath the channel region. In some examples, the sidewall layer forms a second channel parallel to the channel region. In the same or different examples, the sidewall layer has a higher doping concentration than the channel region. In the same or different examples, the sidewall layer has a doping concentration at least 50% greater than the channel region. In the same or different examples, the sidewall layer is formed with a same material as the source region and the channel region. In the same or different examples, the sidewall layer includes a high-mobility 2D material. In the same or different examples, the high-mobility 2D material includes at least one of graphene, hexagonal boron-nitride, transition metal dichalcogenides, and III-VI chalcogenides.

According to another example, a trench FET includes a mesa having a source region and a channel region extending vertically under the source region, a first sidewall layer located along sides of the mesa and including a higher doping concentration of a same doping type as the channel region, a second sidewall layer contacting the first sidewall layer and including an opposite doping type as the first sidewall layer, a gate material contacting the second sidewall layer, the gate material formed with a different material than the second sidewall layer, a shield region formed under the gate material, and a drain layer located beneath the channel region. In some examples, the channel region and the first sidewall layer are n-doped and the second sidewall layer is p-doped. In the same or different examples, the second sidewall layer includes a bottom portion that extends horizontally over the shield region.

Those skilled in the art will appreciate the scope of the disclosure and realize additional aspects thereof after reading the following detailed description in association with the accompanying drawings.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a cross-sectional view of an n-channel trench junction field-effect transistor (FET) with p-type doped sidewalls within the mesa.
FIG. 2A illustrates a cross-sectional view of a trench FET in accordance with embodiments of the present disclosure.
FIG. 2B illustrates a cross-sectional view of a trench FET with a doped shield region beneath the mesa in accordance with embodiments of the present disclosure.
FIG. 2C is a three-dimension cross-sectional view of a trench FET with a doped shield region beneath the mesa in accordance with embodiments of the present disclosure.
FIG. 3A illustrates a cross-sectional view of a trench FET with an n-type material mesa in accordance with embodiments of the present disclosure.
FIG. 3B illustrates a cross-sectional view of a trench FET with multiple channels in the mesa and a current spreading region underneath the mesa in accordance with embodiments of the present disclosure.
FIG. 3C illustrates a cross-sectional view of a trench FET with a current spreading region underneath the mesa in accordance with embodiments of the present disclosure.
FIG. 3D illustrates a cross-sectional view of a trench FET with metal plugs to improve contact with shield regions in accordance with embodiments of the present disclosure.
FIG. 3E illustrates a cross-sectional view of a trench FET with variable doping in the source region in the mesa top in accordance with embodiments of the present disclosure.
FIG. 3F illustrates a cross-sectional view of a trench FET with a mesa having thin n-type material sidewalls in accordance with embodiments of the present disclosure.
FIG. 3G illustrates a cross-sectional view of a trench FET with a mesa having high-mobility material sidewalls in accordance with embodiments of the present disclosure.
FIG. 3H illustrates a cross-sectional view of a trench FET with a mesa having n-type material sidewalls capped with p-type material gate layers in accordance with embodiments of the present disclosure.
FIG. 3I illustrates a cross-sectional view of a trench FET with p-type material gate layers extending over the shield region in accordance with embodiments of the present disclosure.
FIG. 3J illustrates a cross-sectional view of a trench FET with a super-junction structure in accordance with embodiments of the present disclosure.
FIG. 3K illustrates a cross-sectional view of a trench FET with a partial super-junction structure in the drift layer in accordance with embodiments of the present disclosure.
FIG. 4 is a flowchart illustrating a process for forming a trench FET in accordance with embodiments of the present disclosure.
FIGS. 5A-5H illustrate intermediate structures coinciding with steps of the process of FIG. 4 in accordance with embodiments of the present disclosure.
FIG. 6 is a flowchart illustrating a process for forming a trench FET in accordance with embodiments of the present disclosure.
FIGS. 7A-7E illustrate intermediate structures coinciding with steps of the process of FIG. 6 in accordance with embodiments of the present disclosure.
FIG. 8 is a flowchart illustrating a process for forming a trench FET in accordance with embodiments of the present disclosure.
FIGS. 9A-9C illustrate intermediate structures coinciding with steps of the process of FIG. 8 in accordance with embodiments of the present disclosure.
FIG. 10A is a block diagram of a cascode switch in accordance with embodiments of the present disclosure.
FIG. 10B is a block diagram of a half-bridge circuit in accordance with embodiments of the present disclosure.
FIG. 10C is a block diagram of a full-bridge circuit in accordance with embodiments of the present disclosure.
FIG. 10D is an block diagram for an single-phase onboard charger in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following description and in the claims, the terms "including" and "comprising" are used in an open-ended fashion, and thus should be interpreted to mean "including, but not limited to." Also, the term "couple" or "coupled" is intended to mean either an indirect or direct connection. Thus, if a first device couples to, or is coupled to, a second device, that connection between the first device and the second device may be through a direct connection or through an indirect connection via other elements and connections.

Further, although the terms "first," "second," and so forth may be used herein to describe various elements, these elements should not be limited by these terms. Terms such as "first" and "second" may be used merely to distinguish one element from another. For example, a first element could be termed a second element, and, similarly, a second element could be termed a first element, without departing from the scope of the present disclosure. Further, the identification of a "first" element, does not necessarily require the presence of a "second" element. As used herein, the term "and/or" includes any and all combinations of one or more of the associated listed items.

For the purposes of the present disclosure, when an element such as a layer, region, or substrate is referred to as being "on" or extending "onto" another element, such element may be directly or indirectly on the other element, or extend directly or indirectly onto the other element. Accordingly, intervening elements may also be present. In contrast, and for the purposes of the present disclosure, when an element such as a layer, region, or substrate is referred to as being "directly on" or extending "directly onto" another element, no intervening elements are present between at least a portion of the element and at least a portion of the other element. Likewise, it will be understood that when an element such as a layer, region, or substrate is referred to as being "over" or extending "over" another element, such element may be directly or indirectly over, or extend directly or indirectly over, the other element. Accordingly, intervening elements may also be present. In contrast, and for the purposes of the present disclosure, when an element such as a layer, region, or substrate is referred to as being "directly over" or extending "directly over" another element, no intervening elements are present between at least a portion of the element and at least a portion of the other element.

Relative terms such as "below" or "above" or "upper" or "lower" or "horizontal" or "vertical" may be used herein to describe a relationship of one element, layer, or region to another element, layer, or region as illustrated in the FIGURES. It will be understood that these terms and those discussed above are intended to encompass different orientations of the device in addition to the orientation depicted in the FIGURES.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

For the purposes of the present disclosure, a "mesa" may refer to semiconductor material between two adjacent etched trenches. Further, for the purposes of the present disclosure, a "different material" means a material having a different chemical nomenclature. For example, for the purposes of the present disclosure, silicon carbide is a considered a different material than polysilicon. Likewise, silicon and silicon carbide, though both semiconductor materials, may be considered different materials relative to each other. Conversely, regions of the same semiconductor material (such as silicon carbide) with different doping profiles would not be considered as "different materials" from each other. That is, an n-doped region of silicon carbide is not considered as a "different material" than a p-doped region of silicon carbide for the purposes of the present disclosure.

Aspects disclosed in the detailed description include trench field-effect transistors (FETs) with a reduced footprint. In particular, various embodiments of trench FETs are described below that reduce or eliminate the conventionally doped sidewalls (of opposite doping type relative to the channel) of the trench mesa. The doped sidewalls may be replaced with a material that differs from the mesa material, such that a hetero-junction or a Schottky-gate is formed. Such replacement may allow a reduction in the mesa width and therefore reduce the pitch dimension. Such reductions may result in a corresponding reduction of on-state resistance (RON) for the trench FET and reduction in chip size. The reduction in chip size may also translates into lower parasitic capacitance and faster switching speeds.

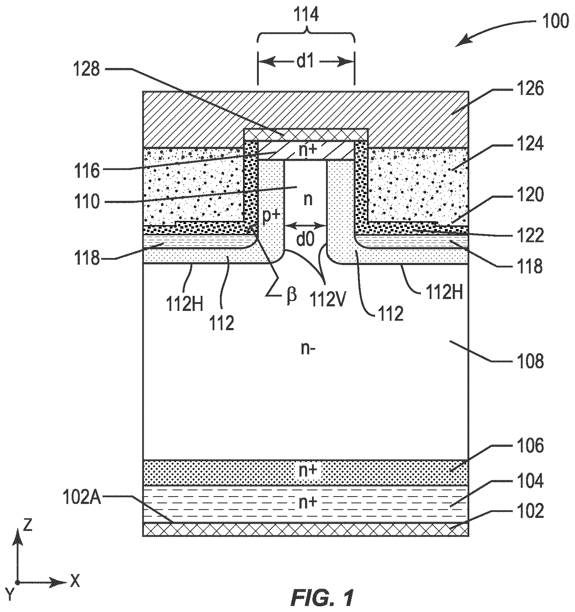

FIG. 1 illustrates a cross-sectional view of an n-channel trench junction field-effect transistor (FET) 100 with p-type doped sidewalls within the mesa. The trench FET devices disclosed herein may be formed as junction field-effect transistors (JFETs) with vertically oriented channels, and thus may also be referred to as JFETs or vertical junction FETs (VJFETs). As shown in FIG. 1, trench FET 100 may have a drain ohmic contact 102 with top surface 102A that lies under a drain layer 104. The drain layer 104 may be formed from a heavily doped n+ bulk semiconductor material. A lighter doped n+ buffer layer 106 may be formed over the drain layer 104, and a drift layer 108 may formed over the buffer layer 106. The drift layer 108 may be a doped n-type material and may be relatively thick and lightly doped compared to other layers such as the buffer layer 106 and the drain layer 104.

A channel layer 110 may be formed from the n-type material near the top of the drift layer 108. As shown in FIG. 1, the channel layer 110 may have a lateral (x-axis) dimension d0. The channel layer 110 may be surrounded by a generally L-shaped sidewall 112 that may be formed from a doped p+ material. The sidewall 112 may be formed from the same basic material as the channel layer 110 (for example, silicon carbide), albeit with different doping. The vertical portion 112V (as opposed to the horizontal portion 112H) of the sidewall 112 may combine with the channel layer 110 to form a mesa 114 that may have a lateral dimension d1 larger than d0. As shown in FIG. 1, the mesa 114 may include a source region 116 at or near the top of the mesa 114. The source region 116 may include a heavily doped n++ material. The horizontal portion 112H of the sidewall 112 may include a heavily doped p++ material region 118. The sidewall 112 may act as a vertical gate for the channel layer 110 with the gate ohmic contact 120. A passivation layer 122 may be positioned on top of the heavily doped p++ material region 118 and along the vertical portion 112V of the sidewall 112, and a dielectric trench fill 124 may be provided over portions of the passivation layer 122. A source metal overlay 126 may be positioned over a metal ohmic contact 128 and the dielectric trench fill 124.

Although the structure of trench FET 100 described above may be good at reducing the overall size of a JFET, the inventors of embodiments of the present disclosure have recognized that further reduction to on-state resistance (RON) and chip size may be achieved by replacing the p-type material sidewalls with a material that differs from the mesa material to form a hetero-junction or Schottky-gate. By changing the p-type material implants used to create the sidewalls in this manner, the mesa width may be decreased with a corresponding decrease in the ohmic resistance. Various techniques for replacing the p-type material are described in further detail below. In various embodiments, the different techniques may be not mutually exclusive to each other, and thus may be combined without departing from the present disclosure.

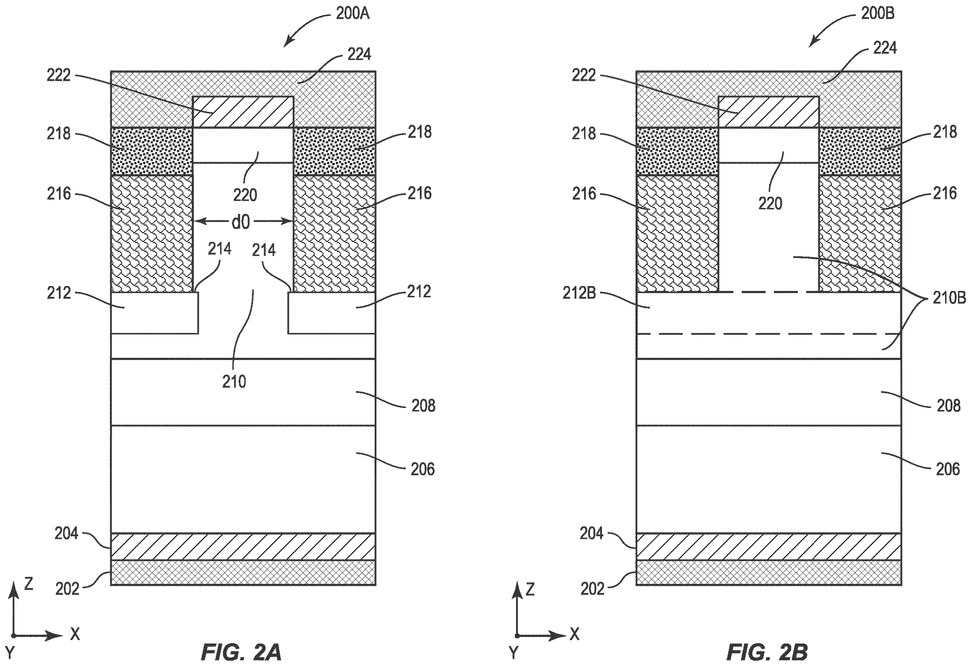

FIG. 2A illustrates a cross-sectional view of a trench FET 200A in accordance with embodiments of the present disclosure. Trench FET 200A may be a JFET device that may be implemented in silicon carbide, for example, or any other suitable semiconductor material. Starting at the bottom and moving up (in the direction of the z-axis), trench FET 200A may include a drain metallization layer 202 and a drain electrode 204 positioned thereon. A drain layer 206 may lie above the drain electrode 204 and below a low-doped n-type drift layer 208. The drain layer 206 may include an epitaxially grown or an ion implanted n+ buffer layer below the drift layer 208. The substrate in which or on which drain layer 206 is formed may contain polycrystalline silicon carbide or any other suitable low-resistivity semiconductor material. The drift layer 208 may be designed to support device-rated voltage with sufficient margin in the off-state. The drift layer 208 may be epitaxially grown and/or may include ion implantation for doping control. In some embodiments, the drift layer 208 may include multiple layers and graded doping.

As shown in FIG. 2A, an n-type channel region 210 may be positioned above the drift layer 208 and may form a mesa having a lateral dimension d0. P-type shield regions 212 may be used to suppress the off-state electric field in the channel region 210 and the trench corner 214 and to suppress drain-induced barrier lowering (DIBL) effects. In some embodiments, the shield regions 212 may be placed beneath the gate material 216 and below the trench bottom, such as by self-aligned vertical ion implantation. And in some embodiments, the shield regions 212 may be oriented orthogonally to the trenches. Ion implantation may be done vertically or under a tilted angle, with or without a spacer, such as with oxide or nitride deposition, and etch back on the mesa sidewalls. The gate material 216 may be formed by a different material compared to the semiconductor material used in the channel region 210. Further, in some embodiments, the gate material 216 may directly contact channel region 210. The gate material 216 may thus form a heterojunction or Schottky-type contact to the channel region 210. By way of example, in embodiments where trench FET 200A (including drain layer 206, drift layer 208, channel region 210, and source region 220) is implemented in silicon carbide, gate material 216 may be formed by degeneratively doped polysilicon (including p-type polysilicon), another semiconductor material different from silicon carbide, metal, or a combination of a metal and another semiconductor material different from silicon carbide.

As shown in FIG. 2A, dielectric material 218 may be located above the gate material 216. For example, dielectric material 218 may be located in some embodiments directly on gate material 216. For the purposes of the present disclosure, dielectric material 218 may also be referred to as an interlayer dielectric layer (ILD). A source region 220 may be positioned on the channel region 210 and may be an n+ region. In some embodiments, the source region 220 may be isolated from direct contact with the gate material 216 to suppress gate-source leakage current. Further, in some embodiments, the source region 220 may consist of several sub-layers of different doping levels to adjust gate-source capacitance and reduce gate-source leakage current. The source region 220 may be coupled to a source electrode 222, which may provide an ohmic contact for the source of trench FET 200A. A source overlay 224 may include a metal material and may connect multiple unit cells in parallel.

As described above, the channel region 210 may form the portion of the mesa between the adjacent gate regions formed by gate material 216. In some embodiments, the channel region 210 may include multiple regions of different doping levels and types, which may be formed epitaxially, by ion implantation, or by combination of such techniques.

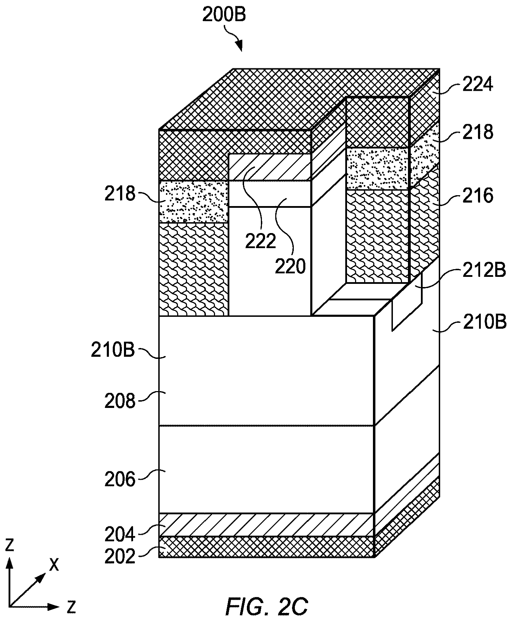

FIG. 2B illustrates a cross-sectional view of a trench FET 200B with a doped shield region beneath the mesa in accordance with embodiments of the present disclosure. FIG. 2C is a three-dimension cross-sectional view of the trench FET 200B with a doped shield region beneath the mesa in accordance with embodiments of the present disclosure. As shown in FIG. 2B and FIG. 2C, trench FET 200B may include certain features (such as a drain metallization layer 202, a drain electrode 204, a drain layer 206, a drift layer 208, gate material 216, dielectric material 218, source region 220, source electrode 222, and source overlay 224) that may be configured and may operate in a similar manner as described above for trench FET 200A in FIG. 2A. As shown in FIGS. 2B and 2C, trench FET 200B may also include a shield region 212B that may be extended across the lateral dimension (x-axis) of the trench FET 200B. As also shown in FIGS. 2B and 2C, the lateral extension of shield region 212B may create gaps between different portions of the channel region 210B.

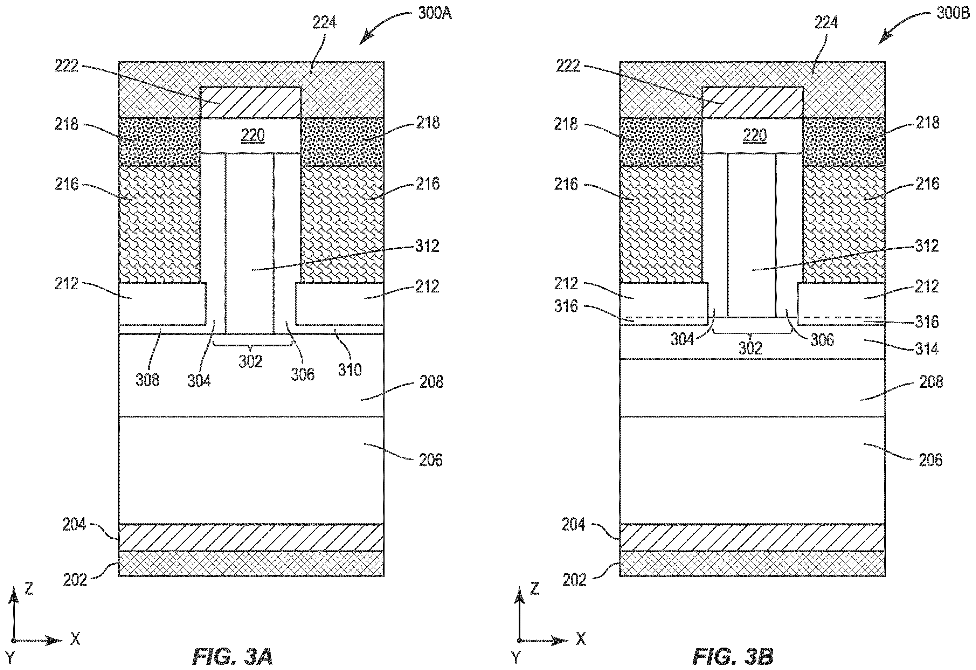

As described below with reference to FIGS. 3A through 3K, various embodiments of the present disclosure may include one or more additional variations relative to either trench FET 200A (shown in FIG. 2A) or trench FET 200B (shown in FIGS. 2B and 2C).

FIG. 3A illustrates a cross-sectional view of a trench FET 300A with an n-type material mesa in accordance with embodiments of the present disclosure. As shown in FIG. 3A, trench FET 300A may include certain features (such as a drain metallization layer 202, a drain electrode 204, a drain layer 206, a drift layer 208, shield regions 212, gate material 216, dielectric material 218, source region 220, source electrode 222, and source overlay 224) that may be configured and may operate in a similar manner as described above for trench FET 200A in FIG. 2A. As further shown in FIG. 3A, trench FET 300A may also include a channel region 302 that includes a central channel 312 located between vertical channels 304 and 306 disposed along the sidewalls of the mesa. In some embodiments, the vertical channels 304 and 306 may differ from the central channel 312 by having differing and higher doping concentration (for example, at least 50% higher) than the central channel 312.

Further, as shown in FIG. 3A, channel region 302 may include wings (such as wings 308 and 310) extending from the vertical channels and under shield regions 212. In some embodiments, the vertical channels 304 and 306 may expand into drift layer 208. Further, vertical channels 304 and 306 may be formed, for example, by shallow ion implantation.

FIG. 3B illustrates a cross-sectional view of a trench FET 300B with multiple channels in the mesa and a current spreading region underneath the mesa in accordance with embodiments of the present disclosure. As shown in FIG. 3B, trench FET 300B may include certain features (such as a drain metallization layer 202, a drain electrode 204, a drain layer 206, a drift layer 208, shield regions 212, gate material 216, dielectric material 218, source region 220, source electrode 222, and source overlay 224) that may be configured and may operate in a similar manner as described above for trench FET 200A in FIG. 2A. As further shown in FIG. 3B, trench FET 300B may include a channel region 302 that includes a central channel 312 located between one or more vertical channels (such as vertical channel 304 and vertical channel 306) disposed along the sidewalls of the mesa. In some embodiments, the vertical channels 304 and 306 may have differing and lighter doping concentration (for example, at least 50% less) than the central channel 312. The central channel 312, in such embodiments, may be formed either by angled ion implantation or by vertical ion implantation at the mesa center.

Trench FET 300B may also include a current spreading layer 314. The current spreading layer 314 may be located between the channel region 302 and the drain layer 206. For example, as shown in FIG. 3B, the current spreading layer 314 may be located underneath the shield regions 212 and adjoining the central channel 312 and the vertical channels 304, 306. In some embodiments, the current spreading layer 314 may surround a lower portion 316 of the respective shield regions 212. The current spreading layer 314 may have a higher doping concentration than the channel region and the drift layer 208. During operation of the trench FET, the current spreading layer 314 may operate to laterally spread the flow of channel current such that current flows more evenly through the drift layer 208.

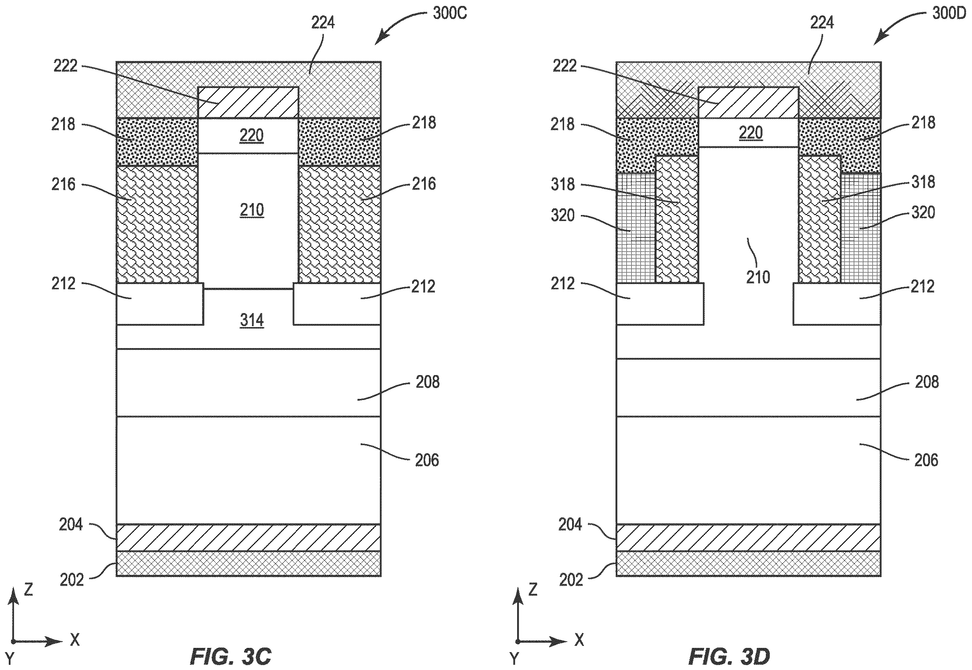

FIG. 3C illustrates a cross-sectional view of a trench FET 300C with a current spreading region underneath the mesa in accordance with embodiments of the present disclosure. As shown in FIG. 3C, trench FET 300C may include certain features (such as a drain metallization layer 202, a drain electrode 204, a drain layer 206, a drift layer 208, channel region 210, shield regions 212, gate material 216, dielectric material 218, source region 220, source electrode 222, and source overlay 224) that may be configured and may operate in a similar manner as described above for trench FET 200A in FIG. 2A. As further shown in FIG. 3C, trench FET 300C may also include a current spreading layer 314 that may be located underneath the shield regions 212 and adjoining the channel region 210. In some embodiments, the current spreading layer 314 may surround lower portions of the respective shield regions 212. The current spreading layer 314 may have a higher doping concentration than the channel region 210 and the drift layer 208. During operation of the trench FET, the current spreading layer 314 may operate to laterally spread the flow of channel current such that current flows more evenly through the drift layer 208.

FIG. 3D illustrates a cross-sectional view of a trench FET 300D with metal plugs to improve contact with shield regions in accordance with embodiments of the present disclosure. As shown in FIG. 3D, trench FET 300D may include certain features (such as a drain metallization layer 202, a drain electrode 204, a drain layer 206, a drift layer 208, channel region 210, shield regions 212, dielectric material 218, source region 220, source electrode 222, and source overlay 224) that may be configured and may operate in a similar manner as described above for trench FET 200A in FIG. 2A. Trench FET 300D may also include a gate material 318 that has been thinned and backstopped by metal plugs 320. The gate material 318 may be formed by a different material compared to the semiconductor material used in the channel region 210. Further, in some embodiments, the gate material 318 may directly contact channel region 210. The gate material 318 may thus form a heterojunction or Schottky-type contact to the channel region 210. By way of example, in embodiments where trench FET 300D (including drain layer 206, drift layer 208, channel region 210, and source region 220) is implemented in silicon carbide, gate material 318 may be formed by degeneratively doped polysilicon (including p-type polysilicon), another semiconductor material different from silicon carbide, metal, or a combination of a metal and another semiconductor material different from silicon carbide.

As shown in FIG. 3D, such addition may change the shape of the dielectric material 218 relative to the shape of dielectric material in trench FET 200A (shown in FIG. 2A) for example. The metal plugs 320 may be in direct electrical contact with both gate material 318 and shield regions 212, thereby forming an ohmic contact with the shield regions 212. Further, such inclusion of metal plugs 320 may reduce a distributed device gate resistance of the trench FET.

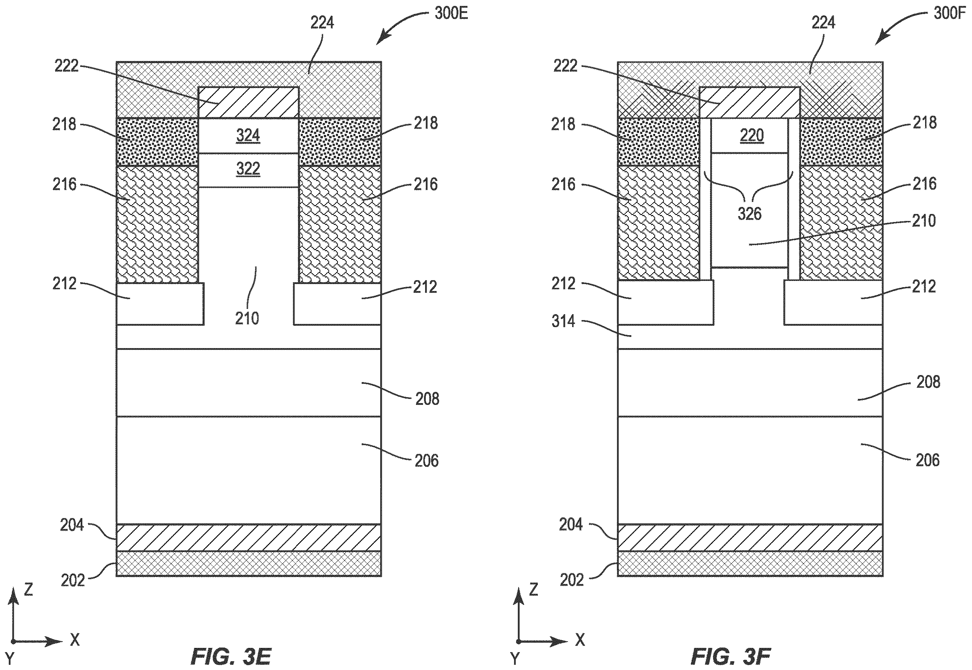

FIG. 3E illustrates a cross-sectional view of a trench FET 300E with variable doping in the source region in the mesa top in accordance with embodiments of the present disclosure. As shown in FIG. 3E, trench FET 300E may include certain features (such as a drain metallization layer 202, a drain electrode 204, a drain layer 206, a drift layer 208, channel region 210, shield regions 212, gate material 216, dielectric material 218, source electrode 222, and source overlay 224) that may be configured and may operate in a similar manner as described above for trench FET 200A in FIG. 2A. As shown in FIG. 3E, trench FET 300E may also include a source region that may include a first source-region portion 322 and a second source-region portion 324. The second source-region portion 324 may be located above the first source-region portion 322 and may include a higher doping concentration than the first source-region portion 322. In some embodiments, first source-region portion 322 may have an n+ doping that is less than the n+ doping of second source-region portion 324. For example, first source-region portion 322 may have an n+ doping that is at least 25% less than the n+ doping of second source-region portion 324. In some embodiments, the doping of the first source-region portion 322 may be less than that of the second source-region portion 324 to reduce the gate-source capacitance and to reduce the gate-source leakage current. Further, the doping of the second source-region portion 324 may be greater than that of the first source-region portion 322 to provide low-resistivity ohmic contact to the source electrode 222.

FIG. 3F illustrates a cross-sectional view of a trench FET 300F with a mesa having thin n-type material sidewalls in accordance with embodiments of the present disclosure. As shown in FIG. 3F, trench FET 300F may include certain features (such as a drain metallization layer 202, a drain electrode 204, a drain layer 206, a drift layer 208, channel region 210, shield regions 212, gate material 216, dielectric material 218, source region 220, source electrode 222, and source overlay 224) that may be configured and may operate in a similar manner as described above for trench FET 200A in FIG. 2A. As shown in FIG. 3F, the mesa of trench FET 300F may include the source region 220, the channel region 210, and a sidewall layer 326 located along the sides of the mesa. The sidewall layer 326 may include the same doping type (for example, n-type doping) as the source region 220 and the channel region 210. The sidewall layer 326 may be thin, for example, with a width less than the width of the channel region 210. In some embodiments, sidewall layer 326 may be a heavily doped n-type material (similar to delta-doping for example). In some embodiments, the doping level of sidewall layer 326 may be at least 50% higher than the doping level of channel region 210. The sidewall layer 326 may thus act as a second channel parallel to channel region 210.

In some embodiments, the thin sidewall layer 326 may be formed by a combination of epitaxial growth and plasma etching after a trench etch, other ion implantation steps, implant activation annealing, and/or sacrificial oxidation steps. In other embodiments, the thin sidewall layer 326 may be formed by high-temperature diffusion from a nitrogen-rich media. The sidewall layer 326 may thus, in some embodiments, be formed of the same type of material as channel region 210.

The gate material 216 may be formed by a different material compared to the semiconductor material used in the channel region 210 and in sidewall layer 326. Further, in some embodiments, the gate material 216 may directly contact sidewall layer 326. The gate material 216 may thus form a heterojunction or Schottky-type contact to the sidewall layer 326 and channel region 210. By way of example, in embodiments where trench FET 300F (including drain layer 206, drift layer 208, channel region 210, source region 220, and sidewall layer 326) is implemented in silicon carbide, gate material 216 may be formed by degeneratively doped polysilicon (including p-type polysilicon), another semiconductor material different from silicon carbide, metal, or a combination of a metal and another semiconductor material different from silicon carbide.

As further shown in FIG. 3F, trench FET 300F may also include current spreading layer 314 that may be located underneath the shield regions 212 and may extend up through different instances of shield regions 212 to adjoin the channel region 210 and a portion of sidewall layer 326. In some embodiments, the current spreading layer 314 may have a higher doping concentration than the channel region 210 and the drift layer 208, but a lesser doping concentration than sidewall layer 326. During operation of the trench FET, the current spreading layer 314 may operate to laterally spread the flow of channel current such that current flows more evenly through the drift layer 208.

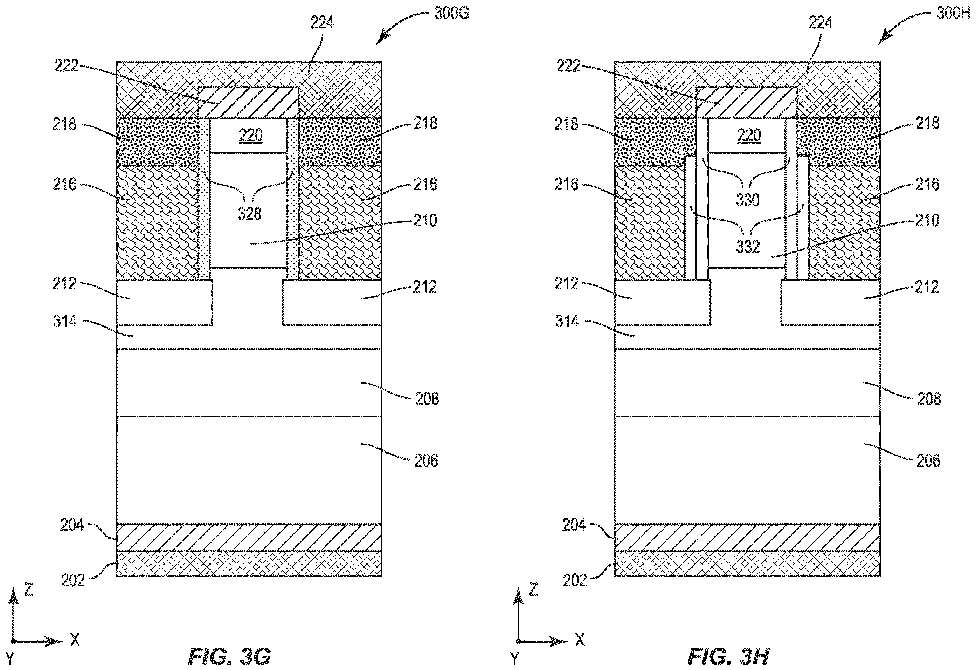

FIG. 3G illustrates a cross-sectional view of a trench FET 300G with a mesa having high-mobility material sidewalls in accordance with embodiments of the present disclosure. Trench FET 300G may be configured in a similar manner as trench FET 300F (shown in FIG. 3F), but may include a mesa having source region 220 and channel region 210, and a sidewall layer 328 located along the sides of the mesa. In some embodiments, the doping of sidewall layer 328 is of the same type as channel region 210 and at a concentration at least 50% higher than the doping of channel region 210. The sidewall layer 328 may thus act as a second channel parallel to channel region 210. The sidewall layer 328 may be thin with a width substantially less than the width of the channel region 210. Although sidewall layer 328 is shown in FIG. 3G as extending the full height of the mesa, the sidewall layer 328 may in some embodiments extend along only a portion of the mesa. For example, in some embodiments, sidewall layer 328 may extend along the sides of the mesa including from the bottom of the mesa a height below that of the source region 220.

In some embodiments, the sidewall layer 328 may be formed with a different material than the mesa including the channel region 210 and the source region 220. For example, in some embodiments, the channel region 210 and source region 220 of the mesa may be formed by n-doped silicon carbide, and the sidewall layer 328 may be formed with a high mobility 2D material such as, but not limited to, graphene, hexagonal boron-nitride, transition metal dichalcogenides, III-VI chalcogenides, or the like.

In some embodiments, the gate material 216 may directly contact the sidewall layer 328, which may in turn directly contact the channel region 210. The sidewall layer 328 may be formed with an atomically thin (for example, only a few atoms thick) high mobility 2D material of the same doping type as the channel region 210, and may thus form an additional channel that is parallel to channel region 210 and has a conductivity that is likewise controlled by the gate. Further, in some embodiments, the gate material 216 may be formed by a different material compared to the semiconductor material used in the channel region 210 and the material of the sidewall layer 328. The gate material 216 may thus form a heterojunction or Schottky-type contact to the sidewall layer 328 and channel region 210. By way of example, in embodiments where trench FET 300F (including drain layer 206, drift layer 208, channel region 210, source region 220) is implemented in silicon carbide, and sidewall layer 328 is implemented with high-mobility 2D material, gate material 216 may be formed by degeneratively doped polysilicon (including p-type polysilicon), another semiconductor material different from silicon carbide, metal, or a combination of a metal and another semiconductor material different from silicon carbide.

FIG. 3H illustrates a cross-sectional view of a trench FET 300H with a mesa having n-type material sidewalls capped with p-type material gate layers in accordance with embodiments of the present disclosure. Trench FET 300H may be configured in a similar manner as trench FET 300G (shown in FIG. 3G), but may include multiple sidewall layers, including first sidewall layer 330 and second side wall layer 332. The first sidewall layer may be located along the sides of the mesa and may include a higher doping concentration of the same doping type as the channel region 210. For example, the first sidewall layer 330 may form thin n-type material channels (similar to sidewall layer 326 described above with reference to FIG. 3F) with a heavier n-type doping concentration than channel region 210. The second sidewall layer 332 may contact the first sidewall layer 330 and may include the opposite doping type as the first sidewall layer 330. For example, the second sidewall layer 332 may be formed by thin p-type material gate regions adjacent to the first sidewall layer 330. The second sidewall layer 332 may be formed by either epitaxial regrowth or by shallow ion implantation for improved threshold voltage control and overall improved device performance. In such embodiments, the second sidewall layer 332 may be formed with the same material (for example, silicon carbide) as the first sidewall layer 330, channel region 210, and source region 220. As shown in FIG. 3H, the second sidewall layer 332 may be separated from and not come into direct contact with the source electrode 222.

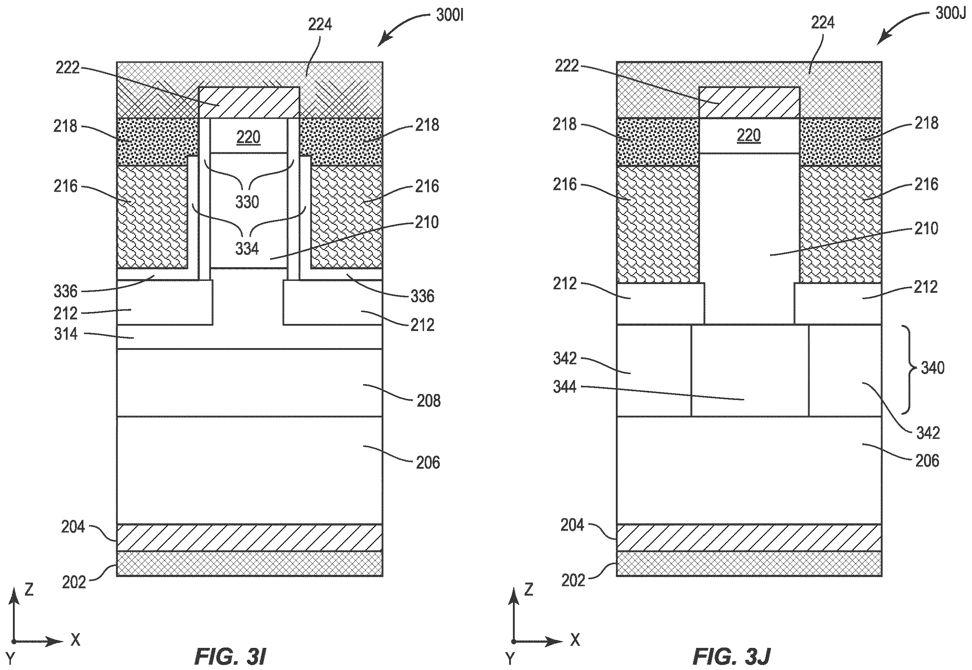

FIG. 3I illustrates a cross-sectional view of a trench FET 300I with p-type material gate layers extending over the shield region in accordance with embodiments of the present disclosure. Trench FET 300I may be configured in a similar manner as trench FET 300H (shown in FIG. 3H), but may include second sidewall layer 334. Similar to second sidewall layer 332 (shown in FIG. 3H), second sidewall layer 334 may be formed by thin p-type material gate regions adjacent to the first sidewall layer 330. The second sidewall layer 334 may be formed by either epitaxial regrowth or by shallow ion implantation for improved threshold voltage control and overall improved device performance. And as shown in FIG. 3I, second sidewall layer 334 may have a bottom portion 336 that is not etched and thus may extend horizontally (in the direction of the x-axis) over the shield regions 212.

FIG. 3J illustrates a cross-sectional view of a trench FET 300K with a super-junction structure in accordance with embodiments of the present disclosure. As shown in FIG. 3J, trench FET 300J may include certain features (such as a drain metallization layer 202, a drain electrode 204, a drain layer 206, channel region 210, shield regions 212, gate material 216, dielectric material 218, source region 220, source electrode 222, and source overlay 224) that may be configured and may operate in a similar manner as described above for trench FET 200A in FIG. 2A.

As shown in FIG. 3J, trench FET 300J may further include a super-junction structure 340 located beneath channel region 210 (in place of drift layer 208 for example). The super-junction structure 340 may be formed from alternating p-type and n-type pillars, such as p-type pillars 342 and n-type pillar 344. In some embodiments, the n-type pillar 344 may be located below the channel region 210 and between adjacent p-type pillars 342. And in some embodiments, the top of the n-type pillar 344 may extend vertically between the shield regions 212 (or above). The opposing charges in the n-type pillar 344 and the p-type pillars 342 may have absolute values that are equal or near-equal to each other. Thus, during an off-state of trench FET 300J, the super-junction structure 340 may produce a vertically uniform maximized electric field throughout the pillars, increasing the breakdown voltage of trench FET 300J. Given the improved breakdown voltage provided by the super-junction structure 340, the doping concentration of n-type pillar 344 may also be increased (relative, for example, to the n-type doping of drift layer 208 in trench FET 200A) to reduce on-state resistance (RON).

In some embodiments, the doping levels in the p-type pillars 342 and n-type pillar 344 may be increased, and the p-type pillars 342 and n-type pillar 344 may be made thinner vertically (shorter in the z-axis) compared to the doping and thickness of the drift layer 208 for the same value of device breakdown voltage, leading to a lower on-state resistance (RON). In some embodiments, the doping and/or the width of the p-type pillars 342 and n-type pillar 344 may be non-uniform in the direction of the z-axis. Further, the p-type pillars 342 and n-type pillar 344 may be formed within a low-doped or undoped epitaxial layer by either deep ion implantation steps or with a sequence of shallower ion implantation and epitaxial regrowth steps.

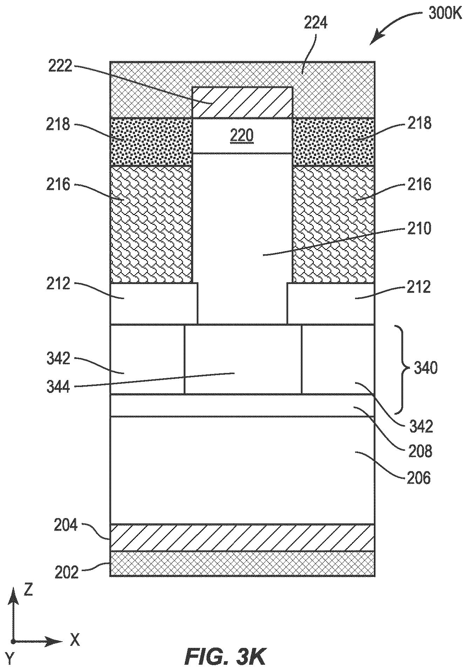

FIG. 3K illustrates a cross-sectional view of a trench FET 300K with a partial super-junction structure in the drift layer in accordance with embodiments of the present disclosure. As shown in FIG. 3K, trench FET 300K may be configured in a similar manner as trench FET 300J (shown in FIG. 3J), but may include both a drift layer 208 and a super-junction structure 340 located above the drift layer 208. The use of both the super-junction structure 340 and the drift layer 208 may balance device performance, parasitic capacitances with better process control, robustness, and lower manufacturing costs.

It should further be appreciated that while the dimensions are shown in particular ratios and sizes in the various FIGS. 2A-2C and 3A-3K the dimensions of different layers with respect to each other may be greater or lesser. For example, although drift layer 208 is illustrated in various figures as being thinner than channel region 210, the drift layer 208 in some embodiments may be thicker (in the direction of the z-axis) than the channel region 210. Further, while the pillars are shown in FIGS. 3J and 3K in a particular orientation relative to the mesa, it should be appreciated that the pillars may be oriented orthogonally to the mesa. For example, while the p-type pillars 342 and n-type pillar 344 are shown in FIGS. 3J and 3K as alternating in the direction of the x-axis and each extending into the page in the direction of the y-axis, in other embodiments the p-type pillars 342 and n-type pillar 344 may be oriented orthogonally to the mesa whereby they alternate in the direction of the y-axis and extend in the direction of the x-axis. Further, as described above with reference to FIGS. 3A through 3K, various embodiments of the present disclosure may include one or more additional variations relative to either trench FET 200A (shown in FIG. 2A) or trench FET 200B (shown in FIGS. 2B and 2C). Although certain of these additional variations are illustrated in different embodiments relative to each other, it is to be understood that some embodiments of the present disclosure may include multiple of the additional variations illustrated in FIGS. 3A through 3K. For example, various embodiments may include the super junction structure illustrated in FIGS. 3J and 3K as well as the multi-doped channel region illustrated in FIGS. 3A and 3B, the current spreading layer illustrated in FIG. 3C, the metal plugs illustrated in FIG. 3D, the multi-doped source region illustrated in FIG. 3E, and/or any one of the sidewall configurations illustrated in FIGS. 3F-3I.

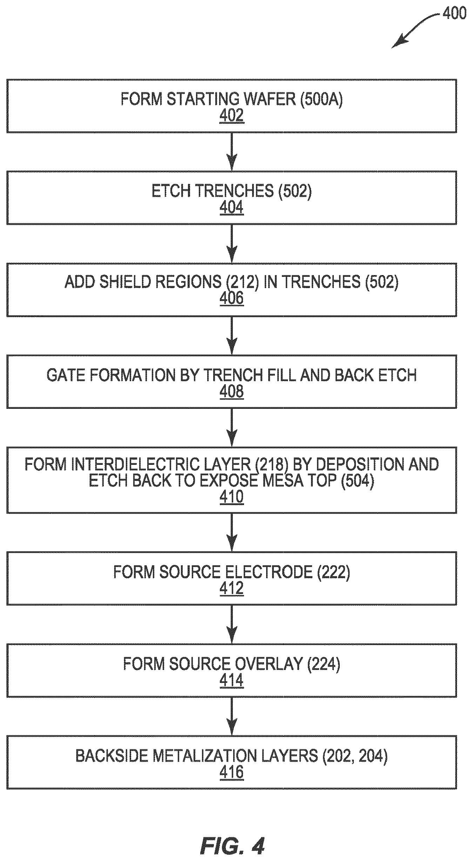

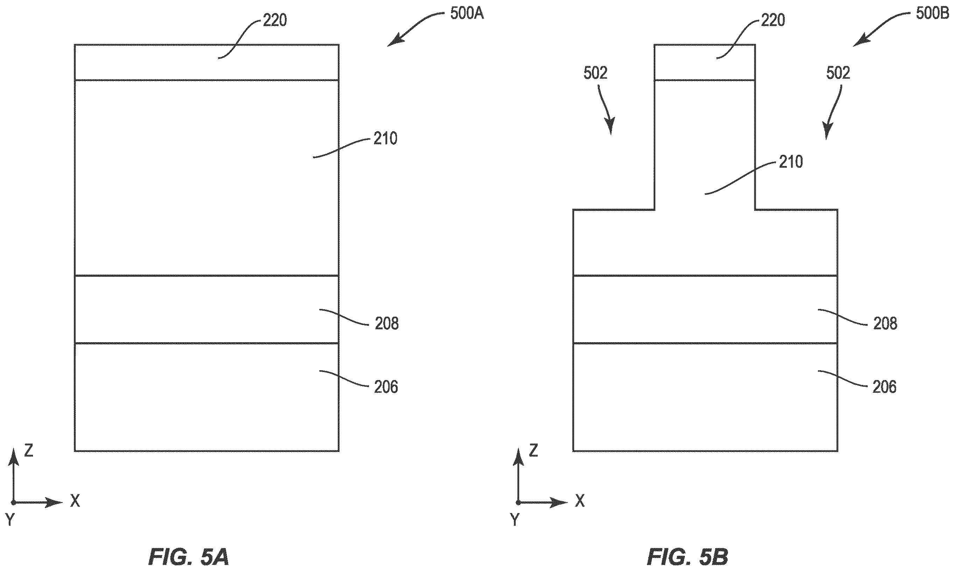

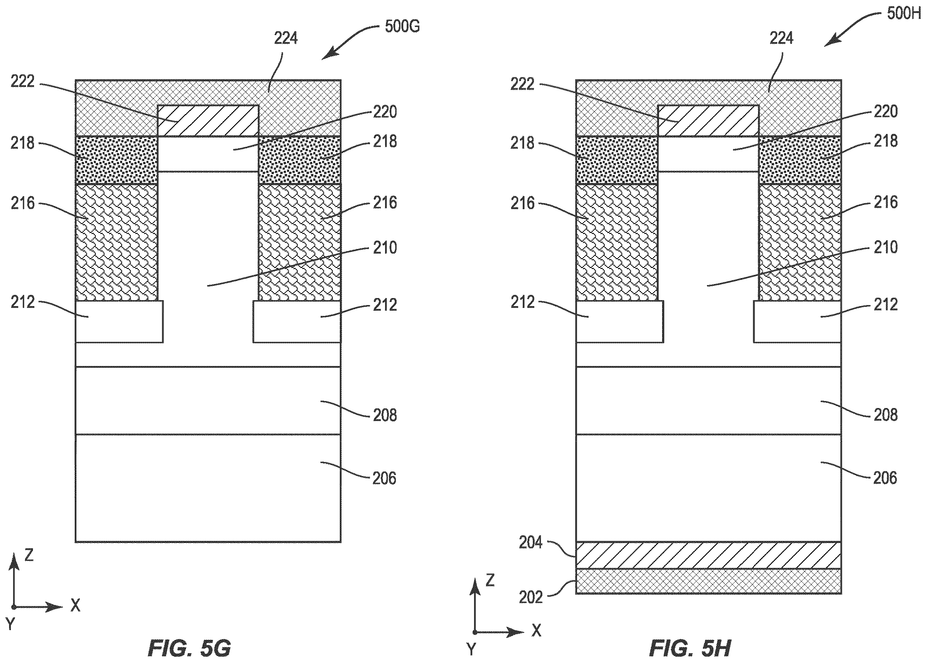

FIG. 4 is a flowchart illustrating a process 400 for forming a trench FET in accordance with embodiments of the present disclosure. FIGS. 5A-5H illustrate intermediate structures coinciding with steps of the process 400 of FIG. 4 in accordance with embodiments of the present disclosure. Specifically, and as described in detail below, FIGS. 5A-5H illustrate intermediate structures coinciding with steps 402-416 of process 400 shown in FIG. 4.

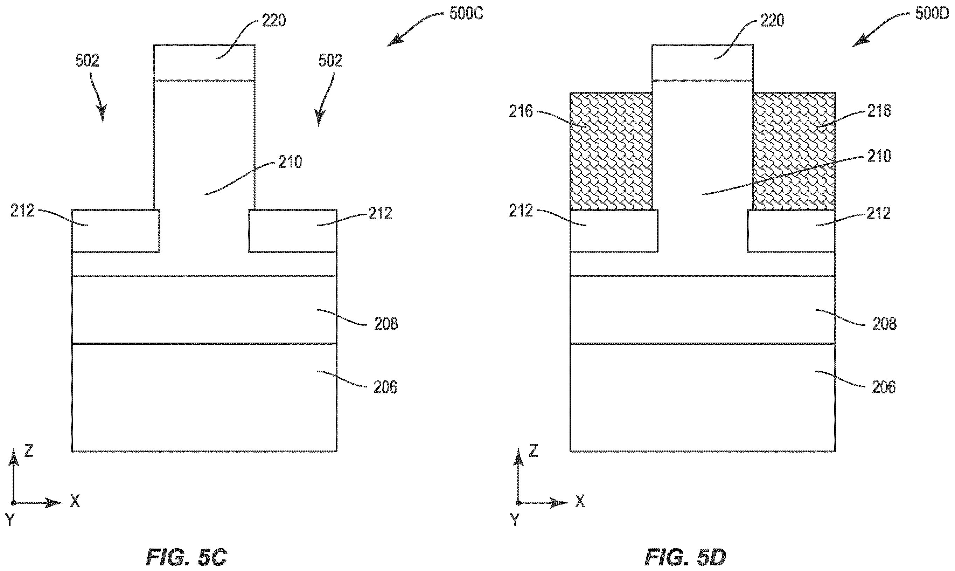

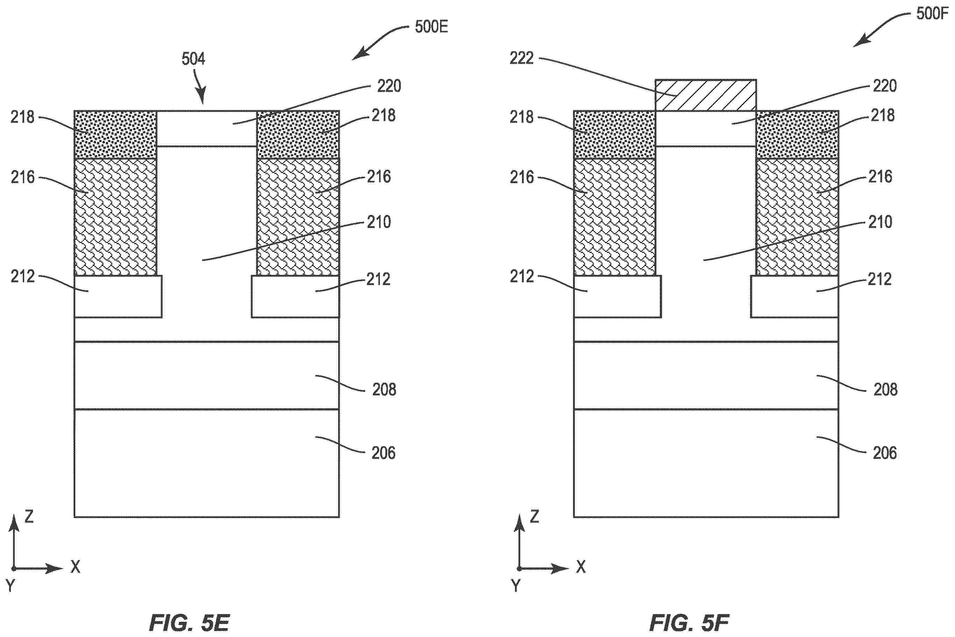

Process 400 may begin at step 402 by forming a starting wafer 500A. As shown in FIG. 5A, starting wafer 500A may include a drain layer 206, a drift layer 208, a channel region 210, and a source region 220. At step 404, trenches 502 may be etched through the source region 220 and part of the channel region 210 to form intermediate structure 500B shown in FIG. 5B. As defined above, the material remaining between these two trenches 502 may be referred to as the mesa. At step 406, shield regions 212 may be added in the trenches 502 to form intermediate structure 500C shown in FIG. 5C. At step 408, gate material 216 may be placed by trench fill and etching to form the gates of intermediate structure 500D shown in FIG. 5D. At step 410, the dielectric material 218 is formed by a deposition and etched back to expose a mesa top 504 to form intermediate structure 500E shown in FIG. 5E.

At step 412, the source electrode 222 may formed as shown by the intermediate structure 500F in FIG. 5F. The source electrode 222 may contain metals such as, but not limited to, nickel (Ni), titanium (Ti), aluminum (Al), tungsten (W), chromium (Cr), various metal silicides, graphite, metal carbides, metal nitrides, and/or other compounds. The source electrode 222 may thus include an ohmic contact interface with the source region 220. The source electrode 222 may be formed through, for example, multi-step metal deposition, thermal annealing, chemical or plasma etching, and/or laser irradiation. At step 414, the process 400 may continue by forming the source overlay 224 as shown by intermediate structure 500G in FIG. 5G. The source overlay 224 connects multiple cell units in parallel and may be a metal that includes sub-layers and alloys of metals, for example, Al, copper (Cu), Ni, gold (Au), platinum (Pt), palladium (Pd), silver (Ag), Ti, TiW, TiN, or the like. The source overlay 224 may promote adhesion and robustness of stacking, clip attach, or wire bonding, depending on the FET application and assembly approach. At step 416, the process 400 may conclude by adding the backside metallization, which may add drain electrode 204 and drain metallization layer 202 to form the final structure 500H, which corresponds to trench FET 200A in FIG. 2A. The drain electrode 204 may contain metals such as, but not limited to, nickel (Ni), titanium (Ti), aluminum (Al), tungsten (W), chromium (Cr), various metal silicides, graphite, metal carbides, metal nitrides, and other compounds and include an ohmic contact interface to the drain layer 206.

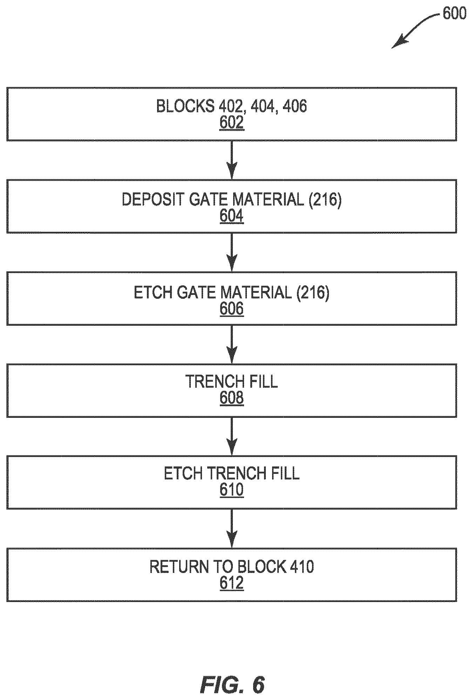

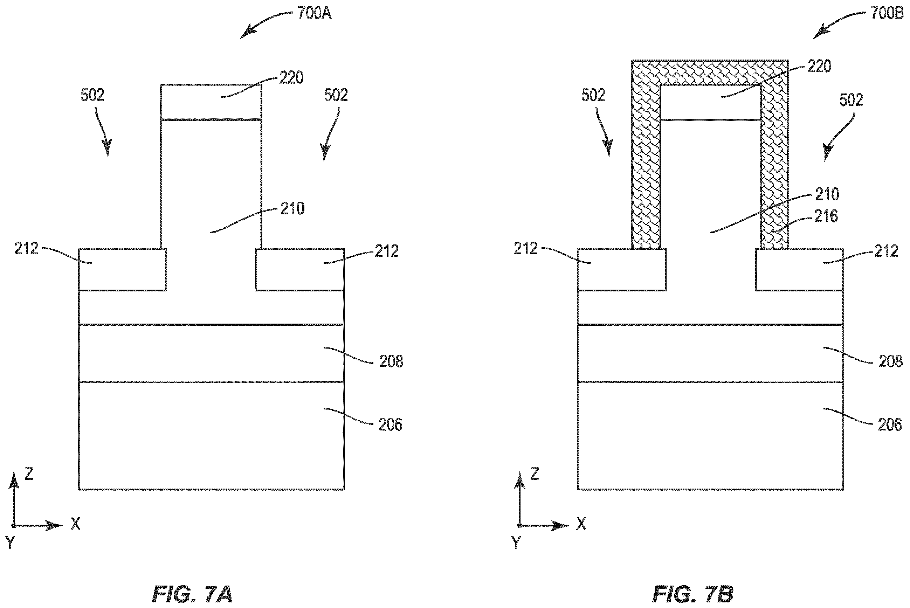

FIG. 6 is a flowchart illustrating a process 600 for forming a trench FET in accordance with embodiments of the present disclosure. Specifically, FIG. 6 illustrates a process 600 for forming trench FET 300D shown in FIG. 3D. FIGS. 7A-7E illustrate intermediate structures coinciding with steps of the process 600 of FIG. 6 in accordance with embodiments of the present disclosure. Specifically, and as described in detail below, FIGS. 7A-7E illustrate intermediate structures coinciding with steps 602-612 of process 600 shown in FIG. 6.

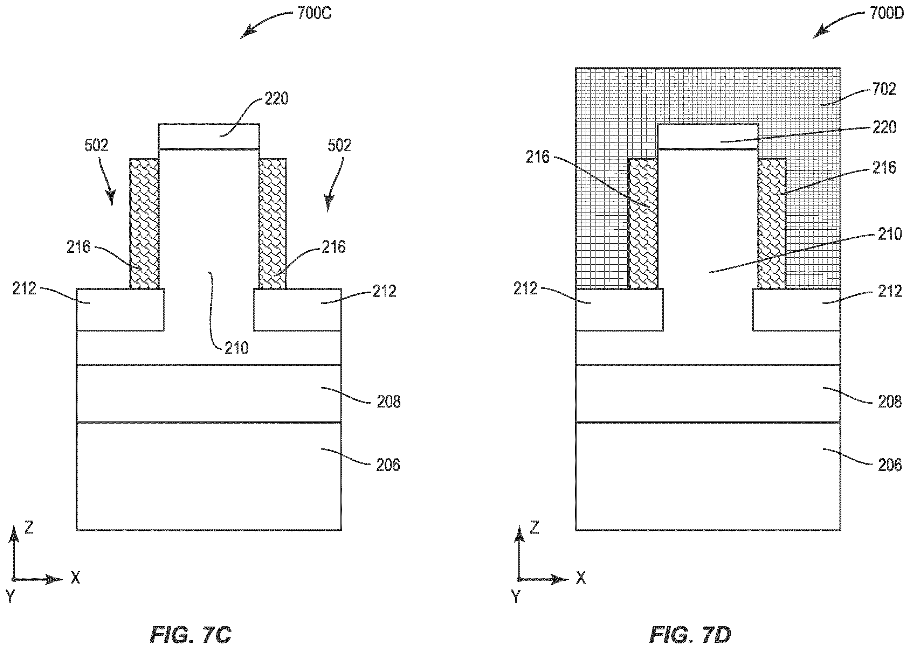

Process 600 may being at step 602 by performing the same steps 402, 404, and 406 described above, resulting in intermediate structure 700A. At step 604, the gate material 216 may be deposited, resulting in intermediate structure 700B shown in FIG. 7B. The gate material 216 may be conformally deposited, for example, but with insufficient thickness to fill trench 502. The gate material 216 may be polysilicon, metal such as tungsten, another semiconductor, or a combination of semiconductor with metal. The gate material 216 may undergo thermal annealing to improve electrical properties and homogeneity of the heterojunction or Schottky-interface with the channel region 210. At step 606, the gate material 216 then be etched back to form intermediate structure 700C shown in FIG. 7C. Additional masking and etching steps may recess the gate material 216 to a desired level in the trench 502 with respect to the source region 220.

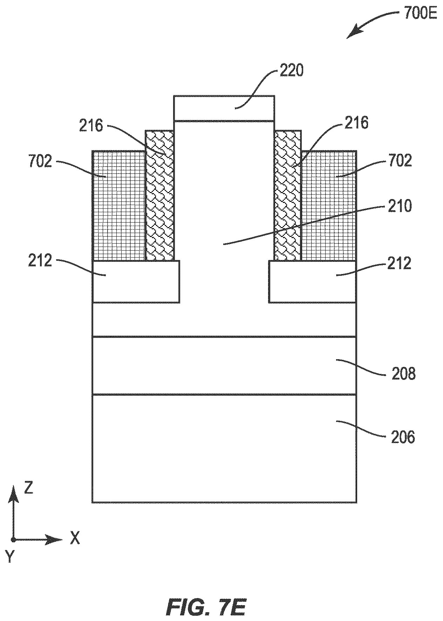

At step 608, the process 600 may continue by filling the trench 502 with trench fill material 702, resulting in intermediate structure 700D shown in FIG. 7D. The trench fill material 702 may be formed by a different material relative to the gate material 216. In some embodiments, the trench fill material 702 may be formed by a deposited metal and may thus include as-deposited ohmic contacts to the p-type shield regions 212. Low-resistivity metal trench fill may reduce device distributed gate resistance, thereby promoting faster FET switching and lower switching losses. At step 610, the trench fill material 702 may be etched back to expose the gate material 216, resulting in intermediate structure 700E shown in FIG. 7E. The trench fill material 702 may undergo thermal treatment to reduce contact resistance to the gate material 216 and p-type shield regions 212. Moving to step 612, the process 600 may finish with the same steps 410, 412, 414, and 416 described above with reference to FIG. 4.

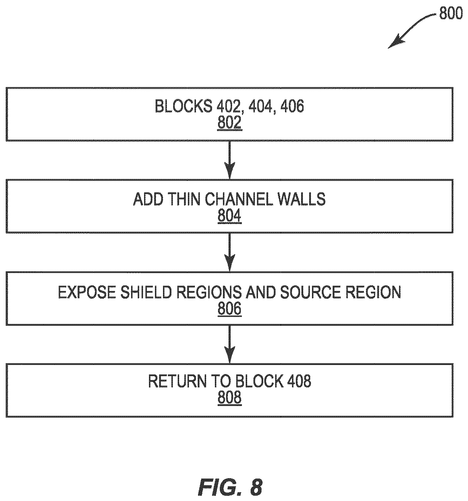

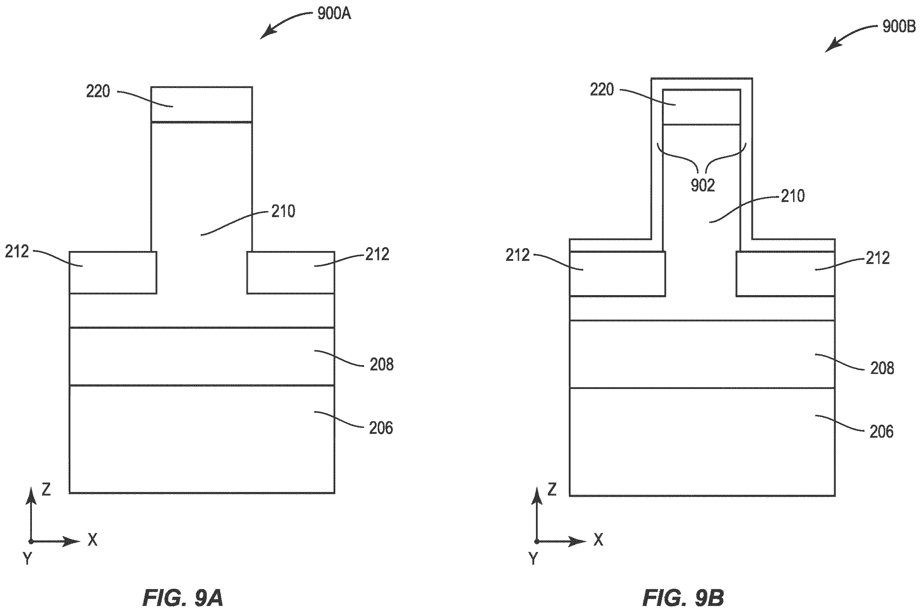

FIG. 8 is a flowchart illustrating a process 800 for forming a trench FET in accordance with embodiments of the present disclosure. FIGS. 9A-9C illustrate intermediate structures coinciding with steps of the process of FIG. 8 in accordance with embodiments of the present disclosure. Specifically, and as described in detail below, FIGS. 9A-9C illustrate intermediate structures coinciding with steps 802-808 of process 800 shown in FIG. 8.

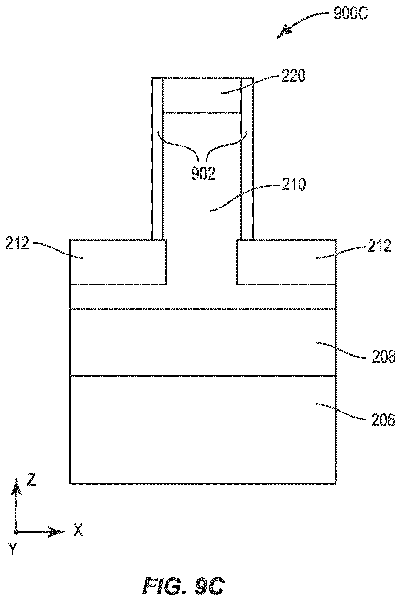

Process 800 may being at step 802 by performing the same steps 402, 404, and 406 described above, resulting in intermediate structure 900A. At step 804, thin channel walls 902 may be formed to form a second channel adjacent to the channel region 210, resulting in intermediate structure 900B shown in FIG. 9B. In some embodiments, the second channel may be a thin n-type material conformally deposited over the mesa and trench surface including mesa sidewalls. The second channel layers may be thin compared to the width of the mesa. Further, the second channel layers may be heavily doped (similar to delta doping). In some embodiments, the maximum doping levels of the second channel layers may be at least 50% higher than the maximum doping levels in the channel region 210. The thin channel walls 902 may be formed by a combination of epitaxial growth and plasma etching after the trench etch, other ion implantation steps, implant activation annealing, and sacrificial oxidation steps. At step 806, shield region 212 and source region 220 may be exposed, resulting in intermediate structure 900C shown in FIG. 9C. The exposure may be implemented with shallow directional etching in plasma, such as inductively coupled plasma (ICP) or the like, and may leave the thin channel walls 902 only on the mesa sidewalls. A similar technique may be used to pattern a combination of deposited thin layers. An additional trench fill with an etching mask, such as an oxide, may further protect some layers at trench bottoms and mesa sidewalls, providing additional design and process versatility. Moving to step 808, the process 800 may continue by resuming the steps 408-416 of process 400 shown in FIG. 4.

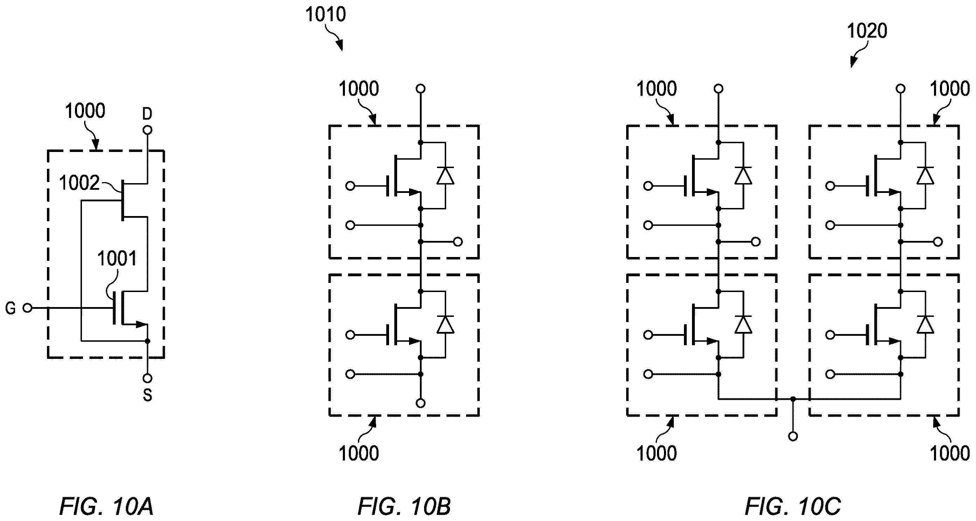

The trench FETs of the present disclosure are well suited for use in cascode-based modules, including half-bridge and full-bridge versions for example, which may then serve as building blocks for more complex circuits, such as EV charging stations, audio amplifiers, and the like. As described below, FIGS. 10A-10D provide illustrative examples of such applications.

FIG. 10A is a block diagram of a cascode switch 1000 in accordance with embodiments of the present disclosure. As shown in FIG. 10A, cascode switch 1000 may include a metal-oxide-semiconductor FET (MOSFET) 1001 and a trench FET 1002. In some embodiments, MOSFET 1001 may be for example a low-voltage rated silicon n-channel MOSFET, and trench FET 1002 may be for example a high-voltage rated silicon carbide (SiC) JFET formed according to the embodiments described above with reference to FIGS. 2A-9C. As shown in FIG. 10A, MOSFET 1001 and trench FET 1002 may be configured in a cascode topology whereby the higher-voltage rated trench FET 1002 protects the lower-voltage rated MOSFET 1001 from high voltages that may be experienced across the cascode switch 1000 in various power applications. For example, MOSFET 1001 may have a source coupled to the source terminal S of cascode switch 1000, a gate coupled to the gate terminal G of cascode switch 1000, and a drain coupled to the source of trench FET 1002. In turn, trench FET 1002 may have a source coupled to the drain of MOSFET 1001, a gate coupled to the source terminal S, and a drain coupled to the drain terminal D of cascode switch 1000. Although trench FET 1002 is illustrated as having a gate coupled to the source terminal S, in some embodiments the gate of trench FET 1002 may be actively driven by a second gate terminal of the cascode switch 1000.

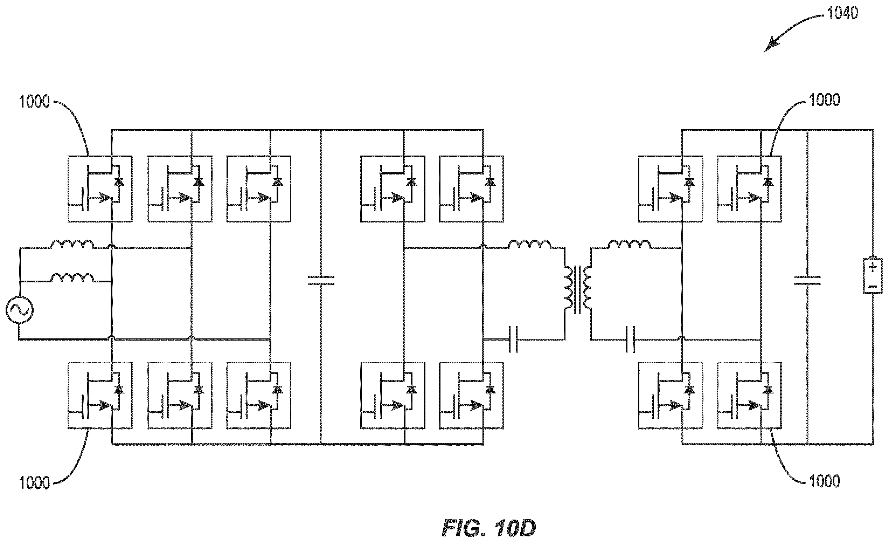

FIG. 10B is a block diagram of a half-bridge circuit 1010 in accordance with embodiments of the present disclosure. FIG. 10C is a block diagram of a full-bridge circuit 1020 in accordance with embodiments of the present disclosure. As shown in FIGS. 10B and 10C, multiple instances of cascode switch 1000 may be coupled together to form, for example, a half-bridge circuit 1010 or a full-bridge circuit 1020. Although illustrated in FIGS. 10B and 10C as a single switch, cascode switch 1000 may in some embodiments include a separate low-voltage MOSFET cascoded by a trench FET as described above with reference to FIG. 10A. The half-bridge and/or full-bridge circuits shown in FIGS. 10B and 10C may be utilized as building blocks for more complex power circuitry. For example, FIG. 10D is an block diagram for an single-phase onboard charger 1040 in accordance with embodiments of the present disclosure. As shown in FIG. 10D, various instances of cascode switch 1000 may provide the high-side and low-side switches for various phases of bridge circuits used to form the single-phase onboard charger 1040, that may be used, for example to charge the batter in an electronic vehicle (EV). Although FIGS. 10A-10D illustrate various applications for a trench FET as part of a cascode switch 1000, in some applications, the various embodiments of trench FETs described herein with reference to FIGS. 2A-9C may also be used as a stand-alone switch.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A trench field-effect transistor (FET) comprising:
a mesa including a source region and a channel region extending vertically under the source region;
a gate material formed with a different material compared to the mesa and contacting sides of the channel region;
a shield region formed under the gate material; and
a drain layer located beneath the channel region.

2. The trench FET of claim 1, further comprising a current spreading layer located between the channel region and the drain layer.

3. The trench FET of claim 1, wherein:
the channel region comprises a central channel located between vertical channels disposed alongside respective sidewalls of the mesa; and
the vertical channels have a higher doping than the central channel.

4. The trench FET of claim 1, wherein:
the channel region comprises a central channel located between vertical channels disposed alongside respective sidewalls of the mesa; and
the vertical channels have a lighter doping than the central channel.

5. The trench FET of claim 1, wherein:
the source region further includes a first source-region portion and a second source-region portion; and
the second source-region portion is located above the first source-region portion and includes a higher doping concentration than the first source-region portion.

6. The trench FET of claim 1, further comprising a metal plug located on the shield region and adjacent to the gate material.

7. The trench FET of claim 1, wherein the gate material forms one of a heterojunction or Schottky-type contact to the channel region.

8. The trench FET of claim 1, further comprising a super-junction structure located beneath the channel region.

9. A trench field-effect transistor (FET) comprising:
a mesa including a source region and a channel region extending vertically under the source region;
a sidewall layer located along sides of the mesa and including a same doping type as the source region and the channel region;
a gate material contacting the sidewall layer, the gate material formed with a different material than the mesa and the sidewall layer;
a shield region formed under the gate material; and
a drain layer located beneath the channel region.

10. The trench FET of claim 9, wherein the sidewall layer forms a second channel parallel to the channel region.

11. The trench FET of claim 9, wherein the sidewall layer has a doping concentration at least 50% greater than the channel region.

12. The trench FET of claim 9, wherein the sidewall layer is formed with a same material as the source region and the channel region.

13. The trench FET of claim 9, wherein the sidewall layer includes a high-mobility 2D material.

14. A trench field-effect transistor (FET) comprising:
a mesa including a source region and a channel region extending vertically under the source region;
a first sidewall layer located along sides of the mesa and including a higher doping concentration of a same doping type as the channel region;
a second sidewall layer contacting the first sidewall layer and including an opposite doping type as the first sidewall layer;
a gate material contacting the second sidewall layer, the gate material formed with a different material than the second sidewall layer;
a shield region formed under the gate material; and
a drain layer located beneath the channel region.

15. The trench FET of claim 14, wherein the channel region and the first sidewall layer are n-doped and the second sidewall layer is p-doped.
